# EUROPEAN PATENT APPLICATION

(11) **EP 4 299 802 A1**
(43) Date of publication of application: **03.01.2024**
(21) Application number: 22759205.2
(22) Date of filing: 26.01.2022
(51) Int. Cl.: C30B 33/06, H01L 21/02, H01L 21/20, H01L 21/205, C30B 29/06, C23C 16/34

(54) **NITRIDE SEMICONDUCTOR SUBSTRATE AND MANUFACTURING METHOD THEREFOR**

(30) Priority: 26.02.2021 JP 2021029830
(71) Applicant: Shin-Etsu Handotai Co., Ltd., Tokyo 100-0004 (JP); SHIN-ETSU CHEMICAL CO., LTD., Tokyo 100-0005 (JP)
(72) Inventor: TSUCHIYA Keitaro, Annaka-shi, Gunma 379-0196 (JP); QU Weifeng, Annaka-shi, Gunma 379-0196 (JP); KUBOTA Yoshihiro, Annaka-shi, Gunma 379-0195 (JP); NAGATA Kazutoshi, Annaka-shi, Gunma 379-0195 (JP)
(74) Representative: Sonnenhauser, Thomas Martin
(86) International application number: PCT/JP2022/002747
(87) International publication number: WO 2022/181163

(57) **Abstract**

The present invention is a nitride semiconductor substrate including: a heat-resistant support substrate having a core including nitride ceramic enclosed in an encapsulating layer; a planarization layer provided on the heat-resistant support substrate; a silicon single crystal layer having a carbon concentration of 1×10¹⁷ atoms/cm³ or higher provided on the planarization layer; a carbonized layer containing silicon carbide as a main component and having a thickness of 4 to 2000 nm provided on the silicon single crystal layer; and a nitride semiconductor layer provided on the carbonized layer. This provides a high-quality nitride semiconductor substrate (a nitride semiconductor substrate particularly suitable for GaN-based high mobility transistors (HEMT) for high-frequency switches, power amplifiers, and power switching devices); and a method for producing the same.

## Description

### TECHNICAL FIELD

The present invention relates to: a nitride semiconductor substrate; and a method for producing the same.

### BACKGROUND ART

Nitride semiconductors, including GaN and AlN, can be used for fabricating high electron mobility transistors (HEMT) that use two-dimensional electron gas, and are therefore expected to be applied to semiconductor devices for high frequencies. Furthermore, such nitride semiconductors are also piezoelectric materials excellent in mechanical properties, and are also expected to be used for high-frequency filters for communication, sensors, energy harvesters, etc. Accordingly, larger diameters, higher quality, and lower costs are desired.

However, production of such nitride semiconductor substrates is difficult, and growth by a common melt growth method as in the case of silicon single crystal substrates is difficult. In industrial application, thin films obtained by vapor deposition on a sapphire, SiC, or Si substrate are used.

Patent Document 1 discloses a technique of using a high resistance silicon substrate in order to obtain a low-cost nitride semiconductor epitaxial substrate having a large diameter. However, a substrate having a high resistance of over 10000 Qcm cannot be obtained with a silicon substrate, and there is a limit to increase in resistivity. Moreover, the thermal conductivity of the substrate is comparatively low, and there are concerns about degradation in properties and reliability in high-frequency devices that generate great heat during operation.

Meanwhile, Patent Document 2 discloses a method of encapsulating inexpensive AlN ceramic with Si₃N₄ or the like, and then forming a group III nitride such as a GaN single crystal by epitaxial growth on a composite substrate having a thin film of a silicone <111> single crystal transferred thereto. However, there are concerns that if a nitride semiconductor is grown by this method, resistivity changes during growth due to heat treatments or impurities being mixed in, so that device characteristics are degraded, even if a Si thin film layer having a controlled resistivity is transferred.

### CITATION LIST

### PATENT LITERATURE

Patent Document 1: JP2020-98839A
Patent Document 2: JP2019-523994A

### SUMMARY OF INVENTION

### TECHNICAL PROBLEM

The present invention has been made in view of the above-described problems. An object of the present invention is to provide: a high-quality nitride semiconductor substrate (a nitride semiconductor substrate particularly suitable for GaN-based high mobility transistors (HEMT) for high-frequency switches, power amplifiers, and power switching devices); and a method for producing the same.

### SOLUTION TO PROBLEM

To achieve the object, the present invention provides a nitride semiconductor substrate comprising:
a heat-resistant support substrate having a core comprising nitride ceramic enclosed in an encapsulating layer;
a planarization layer provided on the heat-resistant support substrate;
a silicon single crystal layer having a carbon concentration of 1×10¹⁷ atoms/cm³ or higher provided on the planarization layer;
a carbonized layer containing silicon carbide as a main component and having a thickness of 4 to 2000 nm provided on the silicon single crystal layer; and
a nitride semiconductor layer provided on the carbonized layer.

In such a nitride semiconductor substrate of the present invention, the silicon single crystal layer has a carbon concentration of 1×10¹⁷ atoms/cm³ or higher and a carbonized layer containing silicon carbide as a main component is provided on the silicon single crystal layer, so that it is possible to suppress the degradation of device characteristics due to changes in resistivity caused by impurities diffusing from the nitride semiconductor layer (epitaxial layer) to the silicon single crystal layer during the growth of the nitride semiconductor layer on the carbonized layer. Moreover, the nitride semiconductor substrate can be manufactured comparatively easily and at a comparatively low cost.

Here, if the thickness of the carbonized layer is less than 4 nm, defects are generated due to growth from portions of the carbonized layer grown in the form of islands having different plane orientations, so that it is not possible to obtain a nitride semiconductor layer having good crystallinity. On the other hand, if the thickness is greater than 2000 nm, the surface roughness of the surface and the warp of the substrate increase, so that the yield of the device is reduced.

In this event, the encapsulating layer can have a thickness of 0.05 to 1.5 µm and
the planarization layer can have a thickness of 0.5 to 3.0 um.

When the encapsulating layer has a thickness of 0.05 um or more, the function of encapsulating substances originating from the core is even more sufficient. Meanwhile, when the thickness is 1.5 um or less, the encapsulating layer can resist effectively the thermal stress between the outer layer and bulk of the encapsulating layer when heating and cooling are repeated in subsequent steps, and delamination can be prevented from occurring.

When the planarization layer has a thickness of 0.5 um or more, voids and unevenness generated in the heat-resistant support substrate can be filled more sufficiently. Meanwhile, when the thickness is 3.0 um or less, the occurrence of warps can be suppressed effectively.

Furthermore, the nitride ceramic can contain polycrystalline aluminum nitride ceramic as a main component.

Such nitride ceramic is excellent in heat resistance and stability and can be obtained with a large diameter at low cost, and is therefore preferable.

Furthermore, the encapsulating layer can be represented by a composition formula of SiOₓN_{y}, provided that x is 0 to 2, y is 0 to 1.5, and x+y > 0.

Such a material is preferable in view of affinity for the nitride ceramic core and strength.

Furthermore, the planarization layer can comprise one of silicon oxide, silicon oxynitride, and aluminum arsenide.

A planarization layer containing such a material can be ground and polished easily at the time of planarization, and can be used as a sacrificial layer for separating the support substrate from the nitride semiconductor layer.

Furthermore, the silicon single crystal layer can have a thickness of 100 to 2000 nm.

When the silicon single crystal layer is as described, a higher quality nitride semiconductor substrate can be achieved.

The present invention also provides a method for producing a nitride semiconductor substrate comprising the steps of:
providing a core comprising nitride ceramic;
forming a heat-resistant support substrate by forming an encapsulating layer so as to enclose the core;
forming a planarization layer on an upper surface of the heat-resistant support substrate;
bonding a silicon single crystal substrate having a carbon concentration of 1×10¹⁷ atoms/cm³ or higher to the planarization layer;
forming a silicon single crystal layer by processing the bonded silicon single crystal substrate to a desired thickness;
forming a carbonized layer having a thickness of 4 to 2000 nm on a surface of the silicon single crystal layer by carbonization in a hydrocarbon atmosphere; and
forming a nitride semiconductor layer on the carbonized layer by epitaxial growth.

According to such a method for producing a nitride semiconductor substrate of the present invention, the silicon single crystal layer and the carbonized layer as described above are formed, and then the nitride semiconductor layer is formed on the carbonized layer by epitaxial growth. Therefore, it is possible to suppress the degradation of device characteristics due to changes in resistivity caused by impurities diffusing from the epitaxial layer to the silicon single crystal layer during the epitaxial growth of the nitride semiconductor layer. Moreover, it is possible to manufacture the above-described nitride semiconductor substrate, the device characteristics thereof being prevented from being degraded, comparatively easily and at a comparatively low cost.

In addition, by forming the carbonized layer to have a thickness of 4 to 2000 nm, a nitride semiconductor layer having good crystallinity can be obtained, and it is also possible to suppress the degradation of the yield of the device due to an increase in surface roughness or the warp of the substrate.

In this event, the encapsulating layer can be formed to have a thickness of 0.05 to 1.5 um and
the planarization layer can be formed to have a thickness of 0.5 to 3.0 um.

When the encapsulating layer is formed to have a thickness within such a range, the substances originating from the core can be encapsulated sufficiently. Furthermore, the encapsulating layer can resist effectively the thermal stress between the outer layer and bulk of the encapsulating layer during heating and cooling in subsequent steps, and delamination can be prevented from occurring.

In addition, when the planarization layer is formed to have a thickness within such a range, voids and unevenness generated in the heat-resistant support substrate can be filled more sufficiently, and the occurrence of warps can be suppressed effectively.

Furthermore, the nitride ceramic can contain polycrystalline aluminum nitride ceramic as a main component.

In this manner, it is possible to obtain large-diameter nitride ceramic having excellent heat resistance and stability at low cost. Therefore, this is preferable.

Furthermore, the encapsulating layer can be represented by a composition formula of SiOₓN_{y}, provided that x is 0 to 2, y is 0 to 1.5, and x+y > 0.

This is preferable in view of affinity for the nitride ceramic core and strength.

Furthermore, the planarization layer can comprise one of silicon oxide, silicon oxynitride, and aluminum arsenide.

In this manner, the planarization layer is easy to grind and polish at the time of planarization, and can be used as a sacrificial layer for separating the support substrate from the nitride semiconductor layer.

Furthermore, the silicon single crystal layer can be formed to have a thickness of 100 to 2000 nm.

In this manner, a nitride semiconductor substrate of higher quality can be manufactured.

### ADVANTAGEOUS EFFECTS OF INVENTION

According to the inventive nitride semiconductor substrate and method for producing the same, it is possible to obtain, at a relatively low cost and relatively easily, a nitride semiconductor substrate in which the degradation of device characteristics is suppressed. Moreover, the nitride semiconductor layer has good crystallinity, suppressed surface roughness, and suppressed warp, and is a high-quality nitride semiconductor substrate.

### BRIEF DESCRIPTION OF DRAWINGS

FIG. 1 is an explanatory diagram showing an example of the constitution of the inventive nitride semiconductor substrate.
FIG. 2 is an explanatory diagram showing an example of the constitution of a nitride semiconductor layer on a composite substrate.
FIG. 3 is an observation image of a surface of a nitride semiconductor layer in Example 1.
FIG. 4 is an observation image of a vertical cross section around a carbonized layer of a nitride semiconductor substrate in Example 1.
FIG. 5 is an observation image of a surface of a nitride semiconductor layer in Comparative Example 1.

### DESCRIPTION OF EMBODIMENTS

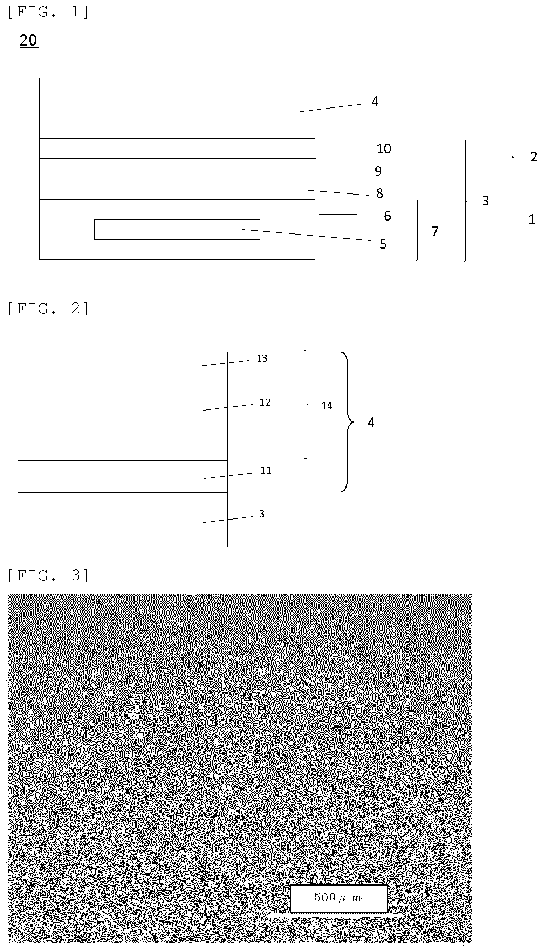

The inventive nitride semiconductor substrate 20 shown in FIG. 1 includes: a composite substrate 3 including a ceramic wafer 1 and a semiconductor layer 2; and a nitride semiconductor layer 4, from which a GaN HEMT is made, for example. The ceramic wafer 1 includes: a heat-resistant support substrate 7 having a core including nitride ceramic (hereinafter, also referred to as a ceramic core) 5 and an encapsulating layer 6 enclosing the ceramic core 5; and a planarization layer 8 provided on the heat-resistant support substrate 7. Here, the semiconductor layer 2 includes a silicon single crystal layer 9 and a carbonized layer 10 in this order from the side of the ceramic wafer 7.

As the ceramic core 5, it is possible to use aluminum nitride (AlN), silicon nitride (Si₃N₄), gallium nitride (GaN), boron nitride (BN), a mixture of these materials, or the like. From the viewpoint of the difference in thermal expansion coefficient and thermal conductivity, the ceramic core is preferably fabricated from ceramic containing polycrystalline AlN as a main component. Polycrystalline AlN is also comparatively inexpensive and can be obtained easily.

The encapsulating layer 6 is a layer for preventing substances contained in the ceramic core 5 from leaking outside, and is formed on the entire surface of the ceramic core 5 so as to enclose the ceramic core 5. When the encapsulating layer 6 has a thickness of 1.5 um or less, it is possible to prevent effectively the encapsulating layer from being likely to be delaminated due to becoming unable to resist the thermal stress between the outer layer and bulk of the encapsulating layer 6 when heating and cooling are repeated in subsequent steps. Meanwhile, a thickness of 0.05 um or more is sufficient for the function of encapsulating substances originating from the ceramic core 5. For the above reasons, the encapsulating layer 6 preferably has a thickness within the range of 0.05 um or more and 1.5 um or less. However, the thickness is not limited thereto.

Furthermore, the encapsulating layer 6 is preferably represented by a composition formula of SiOₓN_{y}, where x is 0 to 2, y is 0 to 1.5, and x+y > 0. This is because such an encapsulating layer is preferable in view of affinity for the ceramic core 5 and strength. The encapsulating layer 6 can be formed by a film formation method such as an MOCVD method, an atmospheric pressure CVD method, an LPCVD (low-pressure CVD) method, or a sputtering method, for example. An LPCVD method is particularly preferably employed, since a fine film can be formed, and moreover, the coverage properties of the film are excellent.

In addition, the planarization layer 8 is stacked on the heat-resistant support substrate 7. By forming the planarization layer 8, voids and unevenness of the heat-resistant support substrate 7 are filled, so that the semiconductor layer 2 can be provided easily by bonding or the like. As the thickness of the planarization layer 8, 0.5 to 3.0 um is suitable, for example. That is, when the planarization layer 8 has a thickness of 0.5 um or more, voids and unevenness generated in the heat-resistant support substrate 7 can be filled more sufficiently. Meanwhile, when the planarization layer 8 has a thickness of 3.0 um or less, warping can be suppressed effectively.

Furthermore, the planarization layer 8 preferably contains one of silicon oxide, silicon oxynitride, and aluminum arsenide. The planarization layer 8 can be formed by plasma CVD, LPCVD, or low-pressure MOCVD, for example, although the film formation method is not limited thereto.

The semiconductor layer 2 includes a silicon single crystal layer 9 and a carbonized layer 10. The silicon single crystal layer 9 can be obtained by thinning a silicon single crystal (silicon single crystal substrate) joined (bonded) with the ceramic wafer 1, and can be fabricated by, for example, delaminating and transferring a part of the joined silicon single crystal substrate. The delamination and transfer methods are not limited to the following. However, for example, the silicon single crystal layer 9 can be fabricated by the steps of: providing a silicon single crystal; forming a fragile layer by implanting ions in the silicon single crystal; and bonding the silicon single crystal with the planarization layer 8 of the ceramic wafer 1, and then delaminating a part of the silicon single crystal at the fragile layer to separate a silicon single crystal layer 9 on the side of the ceramic wafer 1. The ion implantation is not limited to the following elements, but H₂, Ar, He, etc. can be used, for example.

The silicon single crystal layer 9 contains 1×10¹⁷ atoms/cm³ or more of carbon in the outer layer of and inside the silicon single crystal in order to prevent alteration in the resistivity of the silicon single crystal layer 9. Note that the higher the value of the carbon concentration, the easier it is to prevent the diffusion of impurities from the nitride semiconductor layer 4 to the silicon single crystal layer 9, and the easier it is to prevent alteration in the resistivity of the silicon single crystal layer 9. Therefore, the upper limit of the carbon concentration cannot be determined. The method for adding the carbon is not limited to the following, but carbon can be added by ion implantation, heat diffusion from the surface, etc. In particular, the carbon can be added to the silicon single crystal substrate before bonding.

Furthermore, although the thickness of the silicon single crystal layer 9 is not particularly limited, the thickness can be, for example, 100 to 2000 nm. When the thickness is as described, a higher quality nitride semiconductor substrate can be obtained.

The carbonized layer 10 is a layer containing silicon carbide as the main component, and is formed on the silicon single crystal layer 9 with a thickness of 4 nm or more and 2000 nm or less. If the thickness of the carbonized layer 10 is less than 4 nm, defects are generated due to growth from portions of the carbonized layer grown in the form of islands having different plane orientations, so that it is not possible to obtain a nitride semiconductor layer 4 having good crystallinity. On the other hand, if the thickness is greater than 2000 nm, the surface roughness of the surface and the warp of the substrate increase, so that the yield of the device is reduced.

The carbonized layer 10 of the inventive nitride semiconductor substrate 20 can be formed by carbonization in a hydrocarbon atmosphere as described below. For example, the carbonized layer 10 can be formed, for example, by a heat treatment in an atmosphere containing a hydrocarbon or by a CVD method where a hydrocarbon is included as a source gas. In view of productivity and preventing contamination, it is desirable for the carbonized layer 10 to be formed in the same apparatus as that used in the process of forming the nitride semiconductor layer 4 described below.

The nitride semiconductor layer 4 can be fabricated by vapor deposition on the composite substrate 3, for example. An example of the configuration of the nitride semiconductor layer is shown in FIG. 2.

An intermediate layer 11 functions as a buffer layer inserted in order to improve the crystallinity and control the stress of the device layer 14 described below. The intermediate layer 11 is preferably fabricated using a nitride since the intermediate layer 11 can be fabricated using the same facilities.

A device layer 14 including a thin nitride film is provided above the composite substrate 3 and the intermediate layer 11 by vapor deposition by an MOVPE method, sputtering, or the like. The nitride can be, for example, GaN, AlN, InN, AlGaN, InGaN, AlInN, etc. The thin film of the nitride can be 1 to 10 um, and can be designed in accordance with the device.

For example, in a high mobility transistor (HEMT) structure, the device layer 14 is constituted by a gallium nitride layer 12 and an electron supply layer 13 including AlGaN formed on the gallium nitride layer 12. The device layer 14 is preferably a crystal having few crystal defects and few impurities such as carbon and oxygen, in order that device characteristics can be improved, and for example, can be fabricated by an MOVPE method at 900°C to 1350°C.

The inventive nitride semiconductor substrate 20 as described above has the silicon single crystal layer having the above-described carbon concentration and the carbonized layer. Therefore, in the nitride semiconductor substrate, changes in the resistivity of the silicon single crystal layer are suppressed, and furthermore, the degradation of device characteristics is suppressed. In addition, the nitride semiconductor substrate is a high-quality nitride semiconductor substrate having suppressed surface roughness and a suppressed warp. Moreover, the nitride semiconductor substrate can be manufactured at a comparatively low cost and comparatively easily.

Hereinbelow, the inventive method for producing a nitride semiconductor substrate will be described.

### (Step of providing ceramic core)

First, a ceramic core 5 is provided. As described above, AlN, Si₃N₄, GaN, BN, a mixed material thereof, etc. can be used, and a ceramic core containing polycrystalline AlN as a main component is particularly preferable.

### (Step of fabricating heat-resistant support substrate)

Next, an encapsulating layer 6 is formed so as to enclose the fabricated ceramic core 5. Thus, a heat-resistant support substrate 7 is provided. As described above, the encapsulating layer 6 is, for example, represented by the composition formula of SiOₓN_{y}, where x is 0 to 2, y is 0 to 1.5, and x+y > 0, and formed by a film formation method such as an MOCVD method, an atmospheric pressure CVD method, an LPCVD (low-pressure CVD) method, and a sputtering method. Note that the film thickness is preferably in the range of 0.05 um or more and 1.5 um or less.

### (Step of forming planarization layer)

Subsequently, a planarization layer 8 is formed on an upper surface of the heat-resistant support substrate 7. As described above, a layer containing one of silicon oxide, silicon oxynitride, and aluminum arsenide is formed by plasma CVD, LPCVD, or low-pressure MOCVD, for example. Note that the film thickness is preferably in the range of 0.5 to 3.0 um.

Thus, a ceramic wafer 1 is obtained.

### (Step of bonding silicon single crystal substrate to step of forming silicon single crystal layer)

Next, a silicon single crystal substrate having a carbon concentration of 1×10¹⁷ atoms/cm³ or higher is bonded to the planarization layer 8. After that, the bonded silicon single crystal substrate is processed to thin the silicon single crystal substrate to a desired thickness, and thus, a silicon single crystal layer 9 is formed. As the silicon single crystal substrate to be bonded, a silicon single crystal substrate obtained by a CZ method or the like and having the above-described carbon concentration is prepared. Note that the carbon concentration can be adjusted by ion implantation or heat diffusion from the surface.

Subsequently, as described above, H₂ or the like is ion-implanted in the prepared silicon single crystal substrate (formation of a fragile layer), the resulting silicon single crystal substrate is bonded (joined) to the planarization layer 8, and then a part of the silicon single crystal substrate is delaminated at the fragile layer, for example. In this manner, a silicon single crystal layer 9 having a desired thickness (e.g. 100 to 2000 nm) is formed on the planarization layer 8. The conditions of the ion implantation before the bonding can be adjusted to make it possible to achieve the desired thickness after delamination. Besides this method, in the thinning process, the desired thickness can also be achieved by processing the surface of the silicon single crystal substrate by polishing, etching, etc., and both of these means can also be employed.

By processing the composite of the ceramic wafer 1 and the silicon single crystal substrate in this manner, a substrate with an Si layer, the substrate having a silicon single crystal layer 9 formed on a ceramic wafer 1, is obtained.

### (Step of forming carbonized layer to step of forming nitride semiconductor layer)

Hereinbelow, a method for forming the carbonized layer 10 and a method for growing an epitaxial layer suitable for a GaN HEMT are illustrated. Here, the nitride semiconductor layer 4 in the present invention is not particularly limited as long as it is a nitride semiconductor.

### [1] Introduction to reaction furnace

The substrate with the Si layer is introduced into a reaction furnace of an MOVPE apparatus. The substrate with the Si layer is cleaned with a chemical before being introduced into the reaction furnace. After the substrate with the Si layer is introduced into the reaction furnace, the furnace is filled with a high-purity inert gas such as nitrogen, and the gas in the furnace is exhausted.

### [2] Step of cleaning surface of substrate with Si layer in furnace

The substrate with the Si layer is heated in a reaction furnace to clean the surface of the substrate. The temperature for cleaning can be determined between 1000°C and 1200°C in terms of the temperature of the surface of the substrate with the Si layer, and in particular, cleaning at 1050°C can provide a clean surface.

The cleaning is performed after the pressure inside the furnace is reduced, and the pressure inside the furnace can be determined between 200 mbar and 30 mbar (between 200 hPa and 30 hPa). The cleaning can be performed, for example, for about 10 minutes while hydrogen or nitrogen is supplied to the furnace.

### [3] Step of forming carbonized layer 10

In this step, a 4 to 2000-nm carbonized layer containing silicon carbide as a main component is formed on a surface of the substrate with the Si layer by introducing a hydrocarbon to be a raw material into the furnace under a prescribed pressure in the furnace and a prescribed substrate temperature. In this step, the growth is performed under normal pressure at 1200°C, for example. As the carbon source, the carbonization can be performed using CH₄, although the carbon source is not particularly limited thereto.

In this manner, the carbonized layer is formed by performing a carbonization treatment in a hydrocarbon atmosphere, for example, a heat treatment (in a hydrocarbon atmosphere) or CVD (where a hydrocarbon is contained in the source gas). Thus, a composite substrate 3 having a semiconductor layer 2 (silicon single crystal layer 9 and carbonized layer 10) formed on the ceramic wafer 1 is obtained.

### [4] Step of growing intermediate layer 11

In this step, AlN or AlₓGa₁₋ₓN (0 < x ≤ 1) is formed by epitaxial growth on the carbonized layer 10 of the composite substrate 3 by introducing gases to be raw material Al, Ga, and N sources under a prescribed pressure in the furnace and a prescribed substrate temperature.

In this step, the growth can be performed at a pressure of 50 mbar (50 hPa) inside the furnace and a substrate temperature of 1120°C, for example. Trimethylaluminum (TMAl) can be used as an Al source, trimethylgallium (TMGa) can be used as a Ga source, and ammonia (NH₃) can be used as an N source. In addition, in order to obtain a mixed crystal with a desired Al composition, the flow rates of the raw materials TMAl and TMGa are adjusted so that the Al/Ga ratio taken into the thin film is a set ratio, taking into consideration the material efficiency of the source gases. For example, the growth of AlN can be performed with the TMAl flow rate as 0.24 l/min (240 sccm) and the NH₃ flow rate as 2 l/min (2000 sccm). As a carrier gas for the TMAl, TMGa, and NH₃, hydrogen can be used, for example. These conditions are only examples, and are not particularly limited.

### [5] Step of growing gallium nitride layer 12

In this step, GaN or AlₓGa₁₋ₓN (0 < x ≤ 1) is formed by epitaxial growth on the intermediate layer 11 by introducing gases to be raw material Ga and N sources under a prescribed pressure in the furnace and a prescribed substrate temperature.

In this step, the growth can be performed at a pressure of 200 mbar (200 hPa) inside the furnace and a substrate temperature of 1120°C, for example. Trimethylgallium (TMGa) can be used as a Ga source, and ammonia (NH₃) can be used as an N source. In addition, in order to obtain a mixed crystal with a desired Al composition, the flow rates of the raw materials TMAl and TMGa are adjusted so that the Al/Ga ratio taken into the thin film is a set ratio, taking into consideration the material efficiency of the source gases. As a carrier gas for the TMAl, TMGa, and NH₃, hydrogen can be used, for example. These conditions are only examples, and are not particularly limited.

### [6] Step of growing electron supply layer 13

In this step, AlN or AlₓGa₁₋ₓN (0 < x ≤ 0.3) is formed by epitaxial growth on the gallium nitride layer 12 by introducing gases to be raw material Al, Ga, and N sources under a prescribed pressure in the furnace and a prescribed substrate temperature.

In this step, the growth can be performed at a pressure of 150 mbar (150 hPa) inside the furnace and a substrate temperature of 1120°C, for example. Trimethylaluminum (TMAl) can be used as an Al source, trimethylgallium (TMGa) can be used as a Ga source, and ammonia (NH₃) can be used as an N source. In addition, in order to obtain a mixed crystal with a desired Al composition, the flow rates of the raw materials TMAl and TMGa are adjusted so that the Al/Ga ratio taken into the thin film is a set ratio, taking into consideration the material efficiency of the source gases. As a carrier gas for the TMAl, TMGa, and NH₃, hydrogen can be used, for example. These conditions are only examples, and are not particularly limited.

The inventive nitride semiconductor substrate 20 having the nitride semiconductor layer 4 on the composite substrate 3 can be obtained by the above steps.

### EXAMPLE

### (Example 1)

An encapsulating layer (thickness: 0.4 um) made of silicon nitride (Si₃N₄) and 6 um of a planarization layer made of silicon oxide were grown on a substrate made of AlN ceramic (resistivity: 10¹⁴ Qcm or higher). After that, the resultant was polished and planarized to a thickness of 2 um by CMP polishing to achieve a surface roughness Ra of 0.2 nm. Subsequently, a prepared silicon single crystal substrate was bonded to the AlN ceramic substrate on which the encapsulating layer and the planarization layer were stacked, and a part of the silicon single crystal substrate was delaminated. Thus, a silicon single crystal layer (thickness: 300 nm) was formed on the AlN ceramic substrate. Note that the prepared silicon single crystal substrate had a resistivity of 4000 Qcm, a p-type conductivity, and a carbon concentration of 3×10¹⁷ atoms/cm³.

The substrate with the Si layer produced in this manner was introduced into a heat treatment furnace and heated at 1250°C for 10 seconds to form a carbonized layer at a thickness of 4.5 nm. The heat treatment was carried out with the furnace filled with a mixed gas of 1.5% of CH₄ in hydrogen.

An intermediate layer made of AlN and AlGaN and having a superlattice structure, a gallium nitride layer to be a device layer, and an electron supply layer made of AlGaN were grown on the carbonized layer obtained in this manner. Thus, a nitride semiconductor substrate was obtained.

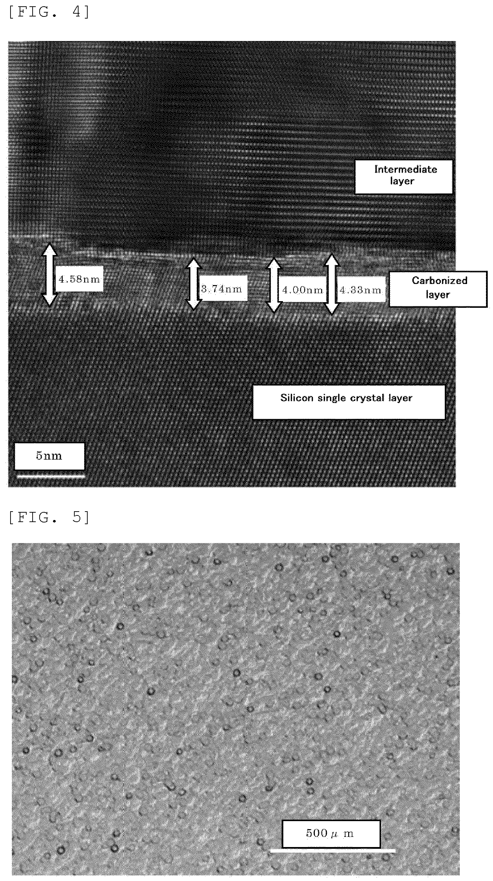

An observation image of a surface of the grown wafer is shown in FIG. 3. In addition, an observation image of a vertical cross section of the wafer is shown in FIG. 4. Meltback etching did not occur, a mirror-plane surface was obtained, and the device layer was of high quality.

### (Comparative Example 1)

A substrate with an Si layer was fabricated in the same manner as in Example 1, and a carbonized layer was formed with a thickness of 2 nm. An intermediate layer made of AlN and AlGaN and having a superlattice structure, a gallium nitride layer to be a device layer, and an electron supply layer made of AlGaN were grown on the carbonized layer.

An observation image of the wafer surface after growth is shown in FIG. 5. Surface roughness occurred and the quality of the device layer was considerably degraded.

### (Comparative Example 2)

A substrate with an Si layer whose silicon single crystal layer had a resistivity of 4000 Qcm and a p-type conductivity was fabricated by the same procedures as in Example 1. No carbonized layer was formed on the substrate with the Si layer, and in the same manner as in Example 1, an intermediate layer made of AlN and AlGaN and having a superlattice structure, a gallium nitride layer to be a device layer, and an electron supply layer made of AlGaN were grown on the silicon single crystal layer.

A coplanar waveguide (CPW) was formed on the fabricated substrates, and the high-frequency characteristics in Example 1 and Comparative Example 2 were measured. As high-frequency characteristics, second harmonic and loss, which are typical characteristics, were measured.

In the case of Example 1, the second harmonic output wave was -73 dBm relative to the fundamental frequency output, and the loss was 1.9 dBm/mm. On the other hand, in the case of Comparative Example 2, the second harmonic output wave was -45 dBm relative to the fundamental frequency output, and the loss was 5.1 dBm/mm.

Note that it can be confirmed that there is little high-frequency distortion and few sneak signals by measuring second harmonic characteristics (the proportion that the frequency component of twice the fundamental frequency is contained), and this indicates that the second harmonic is small. As described above, the second harmonic was smaller in Example 1 than in Comparative Example 2, and it can be observed that parasitic capacity was reduced due to the higher resistivity of the substrate, and the substrate had excellent high-frequency characteristics.

In addition, the silicon single crystal layers (and the original silicon single crystal substrates) of Example 1 and Comparative Examples 1 and 2 were fabricated so as to provide the silicon single crystal layer with a resistivity of 2000 Qcm or higher. However, when the resistivity was actually measured after the epitaxial growth, the desired resistivity was achieved in Example 1, but the resistivity was respectively 12 Qcm and 5 Qcm in Comparative Examples 1 and 2, and the values deviated from the desired resistivity. It is considered that this is because in Comparative Examples 1 and 2, the Al and Ga diffused to the silicon single crystal layer below during the growth of the device layer.

### (Example 2)

A nitride semiconductor substrate was produced in the same manner as in Example 1, except that the thickness of the carbonized layer was set to 4 nm.

### (Example 3)

A nitride semiconductor substrate was produced in the same manner as in Example 1, except that the thickness of the carbonized layer was set to 2000 nm.

### (Example 4)

A nitride semiconductor substrate was produced in the same manner as in Example 1, except that the concentration of carbon in the silicon single crystal substrate (silicon single crystal layer) was set to 1×10¹⁷ atoms/cm³.

### (Comparative Example 3)

A nitride semiconductor substrate was produced in the same manner as in Example 1, except that the thickness of the carbonized layer was set to 2500 nm.

### (Comparative Example 4)

A nitride semiconductor substrate was produced in the same manner as in Example 1, except that the concentration of carbon in the silicon single crystal substrate (silicon single crystal layer) was set to 5×10¹⁶ atoms/cm³.

In Examples 2-4, a nitride semiconductor substrate was successfully obtained. The nitride semiconductor substrates were crystals having an excellent appearance in the surface and vertical cross section of the wafer and being excellent regarding second harmonic and loss, the resistivity of the silicon single crystal layers was not altered from the desired resistivity, and the nitride semiconductor substrates had excellent device characteristics in the same manner as in Example 1.

On the other hand, in Comparative Example 3, the wafer surface was rough, and a warp also occurred. Meanwhile, in Comparative Example 4, the resistivity of the silicon single crystal layer deviated from the desired resistivity.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A nitride semiconductor substrate comprising:
a heat-resistant support substrate having a core comprising nitride ceramic enclosed in an encapsulating layer;
a planarization layer provided on the heat-resistant support substrate;
a silicon single crystal layer having a carbon concentration of 1×10¹⁷ atoms/cm³ or higher provided on the planarization layer;
a carbonized layer containing silicon carbide as a main component and having a thickness of 4 to 2000 nm provided on the silicon single crystal layer; and
a nitride semiconductor layer provided on the carbonized layer.

2. The nitride semiconductor substrate according to claim 1, wherein
the encapsulating layer has a thickness of 0.05 to 1.5 um and
the planarization layer has a thickness of 0.5 to 3.0 um.

3. The nitride semiconductor substrate according to claim 1 or 2, wherein the nitride ceramic contains polycrystalline aluminum nitride ceramic as a main component.

4. The nitride semiconductor substrate according to any one of claims 1 to 3, wherein the encapsulating layer is represented by a composition formula of SiOₓN_{y}, provided that x is 0 to 2, y is 0 to 1.5, and x+y > 0.

5. The nitride semiconductor substrate according to any one of claims 1 to 4, wherein the planarization layer comprises one of silicon oxide, silicon oxynitride, and aluminum arsenide.

6. The nitride semiconductor substrate according to any one of claims 1 to 5, wherein the silicon single crystal layer has a thickness of 100 to 2000 nm.

7. A method for producing a nitride semiconductor substrate comprising the steps of:
providing a core comprising nitride ceramic;
forming a heat-resistant support substrate by forming an encapsulating layer so as to enclose the core;
forming a planarization layer on an upper surface of the heat-resistant support substrate;
bonding a silicon single crystal substrate having a carbon concentration of 1×10¹⁷ atoms/cm³ or higher to the planarization layer;
forming a silicon single crystal layer by processing the bonded silicon single crystal substrate to a desired thickness;
forming a carbonized layer having a thickness of 4 to 2000 nm on a surface of the silicon single crystal layer by carbonization in a hydrocarbon atmosphere; and
forming a nitride semiconductor layer on the carbonized layer by epitaxial growth.

8. The method for producing a nitride semiconductor substrate according to claim 7, wherein
the encapsulating layer is formed to have a thickness of 0.05 to 1.5 um and
the planarization layer is formed to have a thickness of 0.5 to 3.0 um.

9. The method for producing a nitride semiconductor substrate according to claim 7 or 8, wherein the nitride ceramic contains polycrystalline aluminum nitride ceramic as a main component.

10. The method for producing a nitride semiconductor substrate according to any one of claims 7 to 9, wherein the encapsulating layer is represented by a composition formula of SiOₓN_{y}, provided that x is 0 to 2, y is 0 to 1.5, and x+y > 0.

11. The method for producing a nitride semiconductor substrate according to any one of claims 7 to 10, wherein the planarization layer comprises one of silicon oxide, silicon oxynitride, and aluminum arsenide.

12. The method for producing a nitride semiconductor substrate according to any one of claims 7 to 11, wherein the silicon single crystal layer is formed to have a thickness of 100 to 2000 nm.
